# EUROPEAN PATENT APPLICATION

(11) **EP 3 543 372 A1**
(43) Date of publication of application: **25.09.2019**
(21) Application number: 17872640.2
(22) Date of filing: 20.09.2017
(51) Int. Cl.: C23C 18/20, C23C 18/40, H05K 3/18, H05K 3/38

(54) **METHOD FOR PRODUCING PRINTED WIRING BOARD**

(30) Priority: 17.11.2016 JP 2016224208
(71) Applicant: C. Uyemura & Co., Ltd., Osaka-shi, Osaka 541-0045 (JP)
(72) Inventor: SAIJO, Yoshikazu, Hirakata-shi Osaka 573-0065 (JP); YAMAMOTO, Hisamitsu, Hirakata-shi Osaka 573-0065 (JP); NAKA, Nobuhiko, Hirakata-shi Osaka 573-0065 (JP)
(74) Representative: Müller-Boré & Partner Patentanwälte PartG mbB
(86) International application number: PCT/JP2017/033910
(87) International publication number: WO 2018/092410

(57) **Abstract**

The present invention provides a method for producing a novel printed wiring board having much higher adhesion between a filler-containing insulating resin substrate and a plating film. The method comprises the steps of:
subjecting a filler-containing insulating resin substrate to a swelling treatment;
a roughening treatment;
a reduction treatment; and
electroless plating,
wherein the filler-containing insulating resin substrate after the reduction treatment is treated with a first treating solution and a second treating solution, and then is subjected to the electroless plating,
wherein the first treating solution has a pH of 7 or higher and comprises:
at least one selected from the group consisting of ethylene-based glycol ether represented by CmH(2m+1)-(OC₂H₄)n-OH, where m = an integer of 1 to 4, n = an integer of 1 to 4, and propylene-based glycol ether represented by CxH(2x+1)-(OC₃H₆)y-OH, where x = an integer of 1 to 4, y = an integer of 1 to 3, and
wherein the second treating solution has a pH of 7.0 or higher and comprises an amine-based silane coupling agent.

## Description

### TECHNICAL FIELD

The present invention relates to a method for producing a printed wiring board containing a filler in its insulating resin.

### BACKGROUND ART

Printed wiring boards widely used in electronics and other fields are usually produced by applying a catalyst to an insulating resin substrate, carrying out electroless plating such as electroless copper plating, and if necessary, carrying out subsequent electroplating such as electrolytic copper plating. Because no chemical bond is formed between the insulating resin substrate and copper, high adhesion cannot be expected between the insulating resin substrate and a copper plating film. Thus, in the past, there has been so far such a method that after an insulating resin substrate is swollen and then immersed in a roughening solution containing an oxidizing agent such as permanganate or chromate to roughen (etch) the surface of the insulating resin substrate and thus to form an anchor shape, whereby the adhesion between the insulating resin substrate and a copper plating film is enhanced. The above-described roughening solution is also called a desmear solution and is used to remove resin scum (smear) generated in many holes (such as blind vias and through holes for connecting a plurality of conductors and a trench used for forming a circuit) provided on a printed wiring board and on the substrate surface, along with the formation of the holes. A treating method including a series of processes such as the above-described swelling treatment and roughening treatment (etching with an oxidizing agent), a reduction treatment (also called neutralization treatment) for dissolving and removing a residue (such as manganese oxide derived from sodium permanganate) generated on the surface of a resin substrate by the roughening treatment, and a cleaning treatment with a conditioner is called a desmear treatment method.

The insulating resin may often contain a filler such as a silica-based filler, so that the insulating resin substrate can have improved mechanical and electrical characteristics, and at the same time, the anchor effect in the above-described roughening treatment enhances the adhesion between the insulating resin substrate and a plating film.

In recent years, there has been such a problem that conventional desmear treatments cannot yield sufficient adhesion to a plating film, as the printed wiring boards become highly functional and highly integrated. Thus, a technique that enhances the adhesion to a plating film by applying silane coupling to the surface of the substrate is suggested in, for example, Patent Document 1.

### PRIOR ART DOCUMENT

### PATENT DOCUMENT

Patent Document 1: JP2006-219727A

### DISCLOSURE OF THE INVENTION

### PROBLEMS TO BE SOLVED BY THE INVENTION

The present invention has been made to provide a method for producing a novel printed wiring board wherein much higher adhesion between a filler-containing insulating resin substrate and a plating film is achieved.

### SOLUTIONS TO THE PROBLEMS

A method of the present invention for producing a printed wiring board that can have solved the above problem is as follows.

### Item 1

A method for producing a printed wiring board, the method comprising the steps of:
subjecting a filler-containing insulating resin substrate to a swelling treatment;
a roughening treatment;
a reduction treatment; and
electroless plating,
wherein the filler-containing insulating resin substrate after the reduction treatment is treated with a first treating solution and a second treating solution, and then is subjected to the electroless plating,
wherein the first treating solution has a pH of 7 or higher and comprises:
at least one selected from the group consisting of ethylene-based glycol ether represented by CmH(2m+1)-(OC₂H₄)n-OH, where m = an integer of 1 to 4, n = an integer of 1 to 4, and propylene-based glycol ether represented by CxH(2x+1)-(OC₃H₆)_{y}-OH, where x = an integer of 1 to 4, y = an integer of 1 to 3, and
wherein the second treating solution has a pH of 7.0 or higher and comprises an amine-based silane coupling agent.

### Item 2

The method according to above item 1, wherein the filler-containing insulating resin substrate after the treatment with the second treating solution is subjected to a cleaning treatment and then the electroless plating.

### EFFECT OF THE INVENTION

By using the production method of the present invention, a printed wiring board having excellent adhesion between a filler-containing insulating resin substrate and a plating film can be obtained.

Further, a technique of the present invention is applied to not only a production method for a wiring board and production of a high density multilayer wiring board by a build-up construction method, but also production of a multilayer wiring layer in a wafer level CSP (Chip Size epoxy Package or Chip Scale epoxy Package), TCP (Tape Carrier Package), or the like.

### MODE FOR CARRYING OUT THE INVENTION -

The present inventors have been under consideration to provide a surface treating method (desmear treatment) for producing a printed wiring board having good adhesion to a plating film. As a result of it, the present inventors have found it effective to carry out the following two-step treating process after subjecting a filler-containing insulating resin substrate to a swelling treatment, roughening treatment and reduction (neutralization) treatment but before electroless plating (when a cleaning treatment is carried out according to need after the reduction treatment, the two-step treating process is carried out before the cleaning treatment), thereby completing the present invention.

### (1) First Treating Process

A treating process with a first treating solution having a pH of 7 or higher, the solution comprising:
at least one selected from the group consisting of ethylene-based glycol ether represented by CmH(2m+1)-(OC₂H₄)n-OH, where m = an integer of 1 to 4, n = an integer of 1 to 4 and propylene-based glycol ether represented by CxH(2x+1)-(OC₃H₆)y-OH, where x = an integer of 1 to 4, y = an integer of 1 to 3.

### (2) Second Treating Process

A treating process with a second treating solution having a pH of 7.0 or higher and containing an amine-based silane coupling agent, after the above first treating process.

According to the present invention, a printed wiring board having excellent adhesion can be obtained. Therefore, the production method of the present invention may be called, for example, an electroless plating method or an enhancing method for plating adhesion that enhances the adhesion between the substrate and the plating film.

Specifically, in a method for producing a printed wiring board by copper plating, for example, the two-step process is carried out after a reduction treatment but before electroless plating, when a printed wiring board is produced by subjecting a filler-containing insulating resin substrate to a swelling treatment, roughing treatment, reduction treatment (neutralization treatment) for reducing oxides generated from the roughing treatment, [a ultrasonic treatment if necessary, a cleaning treatment (called conditioning, cleaning or the like) if necessary], drying, soft etching, pickling, catalyst imparting, electroless copper plating and electrolytic copper plating. Or, when the ultrasonic treatment and cleaning treatment are further carried out after the above reduction treatment, the above two-step process is carried out after the ultrasonic treatment but before the cleaning treatment. The cleaning treatment may be carried out without carrying out the ultrasonic treatment after the above reduction treatment. In that case, the above two-step process is carried out after the reduction treatment but before the cleaning treatment.

In the present invention, the first treating solution used for the above first treating process may be simply abbreviated to glycol ether. Also, the filler-containing insulating resin substrate may be simply called an insulating resin substrate or a resin substrate.

As described above, in the present invention, it is important to carry out the first treating process in which the glycol ether (the first treating solution) is used prior to the second treating process in which a silane coupling agent and an amine compound (the second treating solution) are used. It is demonstrated in the column of EXAMPLES that reversing this order does not achieve the desired effects. Also, though not described in the Table, carrying out the first treating process and the second treating process simultaneously does not achieve the desired effects. Needless to say, it is demonstrated that carrying out only the first treating process, or carrying out only the second treating process like the above Patent Document 1, does not achieve the desired effects either. Further, in the present invention, controlling the respective pH values in the first and second treating solutions is essential. When the pH values are out of the designated range, it is also confirmed that the desired effects are not achieved.

The above-described processes that characterize the present invention will now be explained.

### (1)First Treating Process

The above-described first treating process uses the first treating solution having a pH of 7 or higher and comprising:
at least one selected from the group consisting of ethylene-based glycol ether represented by CmH(2m+1)-(OC₂H₄)n-OH, where m = an integer of 1 to 4, n = an integer of 1 to 4 and propylene-based glycol ether represented by CxH(2x+l)-(OC₃H₆)y-OH, where x = an integer of 1 to 4, y = an integer of 1 to 3.

The above-described glycol ether is one of the organic solvents, and has been used, for example, as a solvent for paint or ink. The glycol ether may include, for example, the ethylene glycol type (E.O. type) based on ethylene glycol, the propylene glycol type (P.O. type) based on propylene glycol, and other types. The present inventors have found that in the glycol ethers of the E.O. type and the P.O. type, particularly when the ethylene-based glycol ether represented by the following formula (1) and the propylene-based glycol ether represented by the following formula (2) are used, the adhesion between the insulating resin substrate and a plating film is remarkably improved. Although details of reasons for the improvement are not clear, it may be considered that utilization of the above glycol ether improves permeability and thus allows the treating solution to efficiently permeate between a filler and a resin.

CmH(2m+1)-(OC₂H₄)n-OH, where m = an integer of 1 to 4, n = an integer of 1 to 4 ... (1)

CxH(2x+1)-(OC₃H₆)y-OH, where x = an integer of 1 to 4, y = an integer of 1 to 3 ... (2)

Examples of the ethylene-based glycol ether represented by the formula (1) include ethylene glycol methyl ether (n = 1, m = 1), ethylene glycol ethyl ether (n = 1, m = 2), ethylene glycol propyl ether (n = 1, m = 3), ethylene glycol butyl ether (n = 1, m = 4), diethylene glycol methyl ether (n = 2, m = 1), diethylene glycol ethyl ether (n = 2, m = 2), diethylene glycol propyl ether (n = 2, m = 3), diethylene glycol butyl ether (n = 2, m = 4), triethylene glycol methyl ether (n = 3, m = 1), triethylene glycol ethyl ether (n = 3, m = 2), triethylene glycol propyl ether (n = 3, m = 3), triethylene glycol butyl ether (n = 3, m = 4), tetraethylene glycol methyl ether (n = 4, m = 1), tetraethylene glycol ethyl ether (n = 4, m = 2), tetraethylene glycol propyl ether (n = 4, m = 3), and tetraethylene glycol butyl ether (n = 4, m = 4).

Examples of the propylene-based glycol ether represented by the formula (2) include propylene glycol methyl ether (x = 1, y = 1), propylene glycol ethyl ether (y = 1, x = 2), propylene glycol propyl ether (y = 1, x = 3), propylene glycol butyl ether (y = 1, x = 4), dipropylene glycol methyl ether (y = 2, x = 1), dipropylene glycol ethyl ether (y = 2, x = 2), dipropylene glycol propyl ether (y = 2, x = 3), dipropylene glycol butyl ether (y = 2, x = 4), tripropylene glycol methyl ether (y = 3, x = 1) tripropylene glycol ethyl ether (y = 3, x = 2), tripropylene glycol propyl ether (y = 3, x = 3), and tripropylene glycol butyl ether (y = 3, x = 4).

The propyl and butyl in the glycol ethers represented by the above formulae (1) and (2) may have a linear or branched chain structure.

Taking into consideration, for example, a further enhancement of the adhesion, the glycol ether may preferably be ethylene-based glycol butyl ethers represented by the formula (1), and more preferably diethylene glycol butyl ethers (such as diethylene glycol mono-n-butyl ethers).

In the present invention, the glycol ethers represented by the formulae (1) and (2) may be used alone or in combination. As examples of combined use, examples of using two or more glycol ethers represented by the formula (1), examples of using two or more glycol ethers represented by the formula (2), and examples of using at least one glycol ether represented by the formula (1) and at least one glycol ether represented by the formula (2) can be mentioned.

In the above-described first treating solution, a value of the pH finally needs to be controlled to be 7 or higher. As demonstrated in the column of examples described later, if the pH falls below 7, the solution does not effectively exhibit the desired effects. The pH may be preferably 9 or higher, more preferably 10 or higher and further preferably 12 or higher. The upper limit of the pH is preferably approximately 14 or lower, considering damage to the substrate.

The first treating solution contains a pH adjusting agent for controlling the pH to be 7 or higher. A type of the pH adjusting agent is not particularly limited as long as it can adjust the pH to the above range. The type may be, for example, an amine compound such as diethylenetriamine; an alkali solution such as NaOH. An amount of the pH adjusting agent contained in the first treating solution is, though the amount may vary depending on types of utilized glycol ether and the pH adjusting agent, preferably approximately 3 g/L or more and 50 g/L or less, and more preferably 5 g/L or more and 30 g/L or less when, for example, the diethylenetriamine is utilized as the pH adjusting agent.

The first treating solution contains the above-described glycol ether and pH adjusting agent, with the balance consisting of water. In the present invention, the first treating solution does not contain a fluorine compound and a surfactant because the addition of them does not improve the above-described effects.

Here, if a total amount of the glycol ether, pH adjusting agent, and water (if other components are contained, a total amount including them) is defined as 'a whole amount of the first treating solution', the amount of the glycol ether relative to the whole amount of the first treating solution (this amount means the amount of only one glycol ether contained, when the only one glycol ether is contained in the first treating solution, or the total amount of two or more glycol ethers contained, when the two or more glycol ethers are contained in the first treating solution) may be preferably 30 g/L or more and 800 g/L or less, and more preferably 50 g/L or more and 600 g/L or less. When the amount of glycol ether is smaller than the above lower limit, the addition effect of glycol ether is not effectively exhibited, thus lowering plating adhesion. On the other hand, even though glycol ether is added beyond the above upper limit, the addition effect of glycol ether is saturated, thus becoming wasteful from an economical perspective.

In the first treating process, a substrate after the reduction treatment is treated with the first treating solution. Specifically, it is preferable to immerse the substrate after the reduction treatment in the first treating solution. A preferable immersing condition is that solution temperature is from 50 to 90°C and immersion time is from 1 to 20 minutes.

### (2)Second Treating Process

The second treating solution containing an amine-based silane coupling agent and having a pH of 7.0 or higher is used after the above first treating process. An interval between the first and second treating processes is not limited. For example, the second treating process may be carried out immediately after the first treating process, or the second treating process may be carried out after a certain period of time from the first treating process.

The amine-based silane coupling agent used for the second treating solution is represented by the following general formula of a silane coupling agent when Y stands for an amino group. In the formula, X represents an alkoxy group, acetoxy group, a chlorine atom or the like. The amine-based silane coupling agent has in its molecule a functional group Y (amino group) that reacts with and bonds to organic components and, at the same time, a functional group X that reacts with and bonds to inorganic components. Silanol generated from the agent by hydrolysis reacts with and bonds to inorganic components.

Y-R-Si-(X)₃

Examples of the amine-based silane coupling agent preferably used in the present invention include any hydrochloride salts of 3-aminopropyltrimethoxysilane, 3-aminopropyltriethoxysilane, N-2-(aminoethyl)-3-aminopropylmethyldimethoxysilane, N-2-(aminoethyl)-3-aminopropyltrimethoxysilane, 3-triethoxysilyl-N-(1,3-dimethylbutylidene)propylamine, N-phenyl-3-aminopropyltrimethoxysilane and N-(vinylbenzyl)-2-aminoethyl-3-aminopropyltrimethoxysilane.

In the above-described second treating solution, the value of pH finally needs to be controlled to be 7.0 or higher. As demonstrated in the column of EXAMPLES described later, if the pH falls below 7.0, the second treating solution does not effectively exhibit the desired effects. The pH may be preferably 9 or higher and more preferably 10 or higher. The upper limit of the pH is approximately 14 or lower, considering damage to the substrate.

The second treating solution contains a pH adjusting agent for controlling the pH to be 7.0 or higher. A type of the pH adjusting agent is not particularly limited as long as it can adjust the pH to the above range. The type may be, for example, the pH adjusting agent used for the first treating solution, which is descried above.

The second treating solution contains the above-described amine-based silane coupling agent and pH adjusting agent, with the balance consisting of water.

Here, if a total amount of the amine-based silane coupling agent, pH adjusting agent, and water (if other components are contained, a total amount including them) is defined as 'a whole amount of the second treating solution', the amount of the amine-based silane coupling agent relative to the whole amount of the second treating solution (this amount means the amount of only one amine-based silane coupling agent contained, when the only one amine-based silane coupling agent is contained in the second treating solution, or the total amount of two or more amine-based silane coupling agents contained, when the two or more amine-based silane coupling agents are contained in the second treating solution) may be preferably 3 g/L or more and 500 g/L or less, and more preferably 5 g/L or more and 300 g/L or less. When the amount of the amine-based silane coupling agent is smaller than the above lower limit, the addition effect of the amine-based silane coupling agent is not effectively exhibited, thus lowering plating adhesion. On the other hand, even though the amine-based silane coupling agent is added beyond the above upper limit, the addition effect of the amine-based silane coupling agent is saturated, thus becoming wasteful from an economical perspective.

In the second treating process, the substrate that is treated in the above first treating process is treated. Specifically, it is preferable to immerse the substrate after the first treating process in the second treating solution. A preferable immersing condition is that solution temperature is from 40 to 80°C and immersion time is from 1 to 20 minutes.

The method for producing a printed wiring board in the present invention employs the above-described two-step treating process. As to other processes, any common methods typically adopted in the art may be adopted. Thus, the processes are not limited. Specifically, examples of the processes are as follows.

First, an insulating resin substrate containing a filler is prepared. The insulating resin to be used in the present invention is not particularly limited, as long as it is a resin usually used in a desmear treatment and the like. Examples of such an insulating resin include imide resins, phenol formaldehyde resins, novolac resins, melamine resins, polyphenylene ether resins, bismaleimide-triazine resins, siloxane resins, maleimide resins, polyether ether ketone resins, polyether imide resins, polyether sulfone resins and the like in addition to epoxy resins widely used as electrically insulating resins. Needless to say, the present invention is not limited thereto. In addition to the above resins, it is also possible to use, for example, a resin produced by mixing two or more kinds of resins selected from the above-described resins at an arbitrary ratio.

Typical examples of the filler used in the present invention include a silica-based filler. The silica-based filler is useful for improving mechanical and electrical characteristics and the like of the insulating resin substrate and also contributes to improvement in adhesion between the insulating resin substrate and a plating film due to the anchor effect during a roughening treatment.

Then, the filler-containing insulating resin substrate is swollen. By a swelling treatment, the substrate surface is easily roughened in a roughening treatment in the subsequent step. Examples of a swelling solution used in the swelling treatment include N-methyl-2-pyrrolidone, N,N-dimethylacetamide, N,N-dimethyl formamide, γ-butyrolactone, ethylene glycol monobutyl ether and the like. The swelling treatment is preferably carried out by immersing the filler-containing insulating resin substrate in the swelling solution at a temperature of approximately 60 to 90°C for 10 to 30 minutes.

Then, the filler-containing insulating resin substrate after the swelling treatment is washed with water, and then, the substrate surface is roughened (etched). Examples of an etchant used for the roughening treatment include oxidants such as an aqueous sodium permanganate solution, aqueous potassium permanganate solution, aqueous sodium chromate solution, aqueous potassium chromate solution and the like. The roughening treatment is carried out by bringing the filler-containing insulating resin substrate washed with water into contact with an alkali solution of the above etchant. As the contact method, immersion and the like can be mentioned. Specifically, it is preferable that the filler-containing insulating resin substrate is brought into contact at a temperature of approximately 50 to 80°C for 1 to 10 minutes, for example, to roughen the resin surface.

After the surface of the resin substrate is thus roughened, a reduction treatment is carried out. A reduction agent used for the reduction treatment is not particularly limited as long as it is a reduction agent usually used for a reduction treatment after a roughening treatment, and examples of the reducing agent include hydrogen peroxide, hydroxylammonium sulfate, glyoxylic acid, and various amine-based compounds such as hydroxylamine sulfate, ethylenediamine, diethylenetriamine, triethylenetetramine, tetraethylenepentamine, monoethanolamine, diethanolamine, ethylenediaminetetraacetic acid, and nitrilotriacetic acid.

Then, if necessary, a ultrasonic treatment may be carried out, whereby a filler removing effect is enhanced, and the adhesion is further improved. As ultrasonic treatment conditions, for example, it is preferable to control the frequency within a range of 20 to 200 kHz. It is more preferable to control the frequency within a range of 24 to 100 kHz. When the frequency is below the above lower limit, the above effect is not effectively exhibited. On the other hand, when the frequency is beyond the upper limit, damage to the substrate becomes large. In addition, it is preferable to control an ultrasonic irradiation time within a range of approximately 10 seconds to 10 minutes. When the irradiation time is less than 10 seconds, the above effect is not effectively exhibited. On the other hand, if the irradiation time exceeds 10 minutes, excessive etching may occur with respect to an inner layer metal.

Then, the above-described two-step treating process is carried out.

Also, the cleaning treatment may be carried out after the above-described two-step treating process.

By cleaning the resin substrate in the above cleaning treatment, the treatment removes dirt and the like from the surface of the resin substrate to clean the surface and, at the same time, imparts water-wettability to the resin substrate, thus further improving the adhesion to a plating film that is to be formed in the subsequent step. A type of the solution used for this cleaning treatment is not limited, and, for example, a cleaner/conditioner containing at least both a nonionic surfactant and a cationic surfactant is used. Specifically, it is preferable to immerse the above surface-treated resin substrate in the cleaner/conditioner at a temperature of 30 to 70°C for 1 to 10 minutes.

After plating pretreatment is carried out as described above, a plating treatment is carried out. The method of the plating treatment is not limited, and a plating film is formed by adopting a commonly used method such as a semi additive method or a full additive method. For details of the plating treatment, reference can be made, for example, to Patent Document 1 described above and the description in JP2015-71821A.

Hereinafter, a plating treatment method according to the full additive method will be described in detail. In the following example, although formation of a copper plating film will be explained, a type of a plating film is not limited to the copper plating film and may be another metal plating film such as a nickel plating film. Instead of the plating treatment according to the full additive method, a plating film may be formed by electroplating using a semi additive method.

The above-described swelling treatment, roughing treatment, reduction treatment, two-step treating process and, if necessary, cleaning treatment are carried out.

Then, a catalyst is applied to the resin substrate surface on which a circuit pattern is to be formed. A type of the catalyst used for the catalyst application is not particularly limited as long as the catalyst is the commonly used catalyst, and, for example, a catalyst solution containing divalent palladium ions (Pd²⁺), a mixed solution containing palladium chloride (PdCl₂-2H₂O), stannous chloride (SnCl₂-2H₂O), and hydrochloric acid (HCl), or the like can be used. It is preferable that the mixed solution has a concentration of, for example, 100 to 300 mg/L as the Pd concentration, 10 to 20 g/L as the Sn concentration, and 150 to 250 mL/L as the HCl concentration. The insulating resin substrate is immersed in such a catalyst solution at a temperature of 30 to 40°C for 1 to 3 minutes, for example, to first make a Pd-Sn colloid adsorbed on the resin substrate surface. Then, the insulating resin substrate is immersed in an accelerator (promotor) comprising 50 to 100 mL/L of sulfuric acid or hydrochloric acid, for example, under normal temperature conditions to activate the catalyst. Tin is removed from a complex compound by this catalyst activation treatment to provide palladium adsorption particles, which finally serves as a palladium catalyst to promote the subsequent copper deposition by electroless copper plating. Sodium hydroxide or an ammonia solution may be used as the accelerator. When the catalyst is applied to the resin substrate, pretreatment using a conditioner solution or a pre-dipping solution may be carried out to further enhance the adhesion between the resin substrate and the copper plating film, and furthermore, pretreatment for improving the wettability of the catalyst onto the resin substrate surface may be carried out.

Then, after the catalyst is applied to the insulating resin substrate in this way, if necessary, a plating resist for forming a desired circuit pattern is formed. That is, a resist pattern masking other portions than a part to be deposited with a copper plating film constituting a circuit pattern in the next step is formed. The resist pattern may be peeled and removed, after termination of a plating treatment, by etching operation or the like, or the resist pattern may function as a solder resist without being peeled and removed after a plating treatment. A method for forming the plating resist can be carried out using well-known methods.

After the plating resist is formed, a copper plating film is deposited by an electroless plating method to form a circuit pattern. When the copper plating film is to be deposited by the electroless plating method, after the formation of the plating resist, by using 10% sulfuric acid and reducer, for example, palladium adsorption particles of the catalyst adhered on the surface of the resin substrate are reduced to activate the catalyst, and deposition of the copper plating on the resin substrate may be improved.

Specifically, as a plating bath used for the electroless copper plating, for example, a plating bath containing EDTA as a complexing agent can be used. As one example of the composition of the electroless copper plating bath described above, it is possible to use an electroless copper plating bath containing copper sulfate (10 g/L) and EDTA (30 g/L) and being adjusted to a pH of approximately 12.5 with sodium hydroxide. Alternatively, an electroless copper plating bath using Rochelle salt as a complexing agent may be used. The insulating resin substrate is immersed in this electroless copper plating bath at a temperature of 60 to 80°C for 30 to 600 minutes, for example, to form a copper plating film. For example, when a via or the like for electrical conduction with a lower layer is formed in a multilayer wiring board, it is preferable to sufficiently stir the solution so that ions are sufficiently supplied to the via. The stirring method is not limited, and, for example, air stirring or any other stirring such as pump circulation may be adopted as the method.

In this plating treatment, two-step plating may be carried out to further enhance the adhesion to the insulating resin substrate. That is, a first plating treatment to form an underlying plating film on the resin substrate is carried out, and a second plating treatment to form a thick plating film, whose thickness becomes thicker than the underlying plating film, on the formed underlying plating film may be carried out to form a circuit pattern. Particularly in the first plating treatment, the internal stress has a direction different from the direction of the internal stress of the thick plating film formed by the second plating treatment; in other words, the internal stress has a direction opposite to the direction of the internal stress of the thick plating film formed by the second plating treatment, and a plating treatment may be generally carried out using an electroless plating bath to form an underlying plating film having tensile internal stress.

This application claims the benefit of priority to Japanese Patent Application No. 2016-224208, filed on November 17, 2016. The entire contents of the specification of Japanese Patent Application No. 2016-224208, filed on November 17, 2016 are incorporated herein by reference.

### EXAMPLES

Next, the present invention will be described more concretely by way of Examples and Comparative Examples. However, the present invention is by no means limited by modes of the Examples, and may appropriately be modified within a range not deviated from the gist of the present invention.

### Example 1

In this example, the following samples were prepared using a first treating solution and a second treating solution that are listed in Table 1. In Table 1, the first treating solution was adjusted to have a pH of 7 or higher by using NaOH whose concentration was 2 to 20 g/L as a pH adjusting agent, and sulfuric acid was used as a pH adjusting agent for the solution whose pH was lower than 7. Also, the second treating solution was adjusted to have a pH of 7.0 or higher by using diethylenetriamine as a pH adjusting agent, and sulfuric acid was used as a pH adjusting agent for the solution whose pH was lower than 7.0.

Concretely, a resin substrate prepared by laminating a photosensitive resin (PVI-1 EL100) available from TAIYO INK MFG. CO., LTD. was subjected, as shown in Table 2, to a swelling treatment, roughening treatment, neutralization (reduction) treatment, ultrasonic treatment (frequency: 28 kHz), two-step process, which is shown in Table 1, drying and a treatment with cleaner/conditioner (cleaning treatment). The surface roughness Ra at this time was 0.45 µm. Then, the insulating resin substrates were softly etched, pickled, and provided with a Pd catalyst by the catalyst imparting process (predip, activator, reducer, and accelerator), followed by electroless copper plating and drying to form a plating film of 0.8 µm in thickness. Further, the plated substrates were dried, heat treated, cleaned, and pickled, followed by electrolytic copper plating under the condition of 2.5 A/dm² to form a copper plating film of 25 µm in thickness. The plated substrates were then subjected to a discoloration preventive treatment, drying, and a heat treatment to prepare the samples.

The samples thus prepared were measured for adhesion strength between a plating film and an insulating resin substrate as follows.

### (Measurement of Adhesion Strength between Plating Film and Insulating Resin Substrate)

A cut of 1 cm in width was made in each of the above samples, followed by 90° peel test according to the method as described in JIS-C5012, "8.5 Plating Adhesion", to measure peel strength with Autograph AGS-X Series Precision Universal Tester available from Shimadzu Corporation.

The results are shown in Table 1.

**[Table 1A]**

| Test No. | First treating solution | | | | | | | | A | | | | Adhesion |
|---|---|---|---|---|---|---|---|---|---|---|---|---|---|
| | Glycol ether | | | n or y | m or x | Concentration of pH adjusting agent | | pH | Silane coupling agent | | pH adjusting agent | pH | |
| | Classification | Type | Concentration | | | NaOH | Sulfuric acid | | Type | Concentration | | | Peel strength |
| 1 | | Ethylene glycol monomethyl ether | 150g/L | 1 | 1 | 10g/L | - | 13.1 | 3-aminopropyltriethoxysilane | 20g/L | Diethylenetriamine | 10.8 | 544gf/cm |
| 2 | | Ethylene glycol monopropyl ether | 150g/L | 1 | 3 | 10g/L | - | 13.1 | 3-aminopropyltriethoxysilane | 20g/L | Diethylenetriamine | 10.8 | 529gf/cm |
| 3 | | Ethylene glycol mono-n-butyl ether | 150g/L | 1 | 4 | 10g/L | - | 13.1 | 3-aminopropyltriethoxysilane | 20g/L | Diethylenetriamine | 10.8 | 510gf/cm |
| 4 | | Diethylene glycol mono-n-butyl ether | 100g/L | 2 | 4 | 10g/L | - | 13.1 | 3_{'}aminopropyltriethoxysilane | 20g/L | Diethylenetriamine | 10.8 | 550gf/cm |
| 5 | | Diethylene glycol mono-n-butyl ether | 150g/L | 2 | 4 | 10g/L | - | 13.2 | 3-aminopropyltriethoxysilane | 10g/L | Diethylenetriamine | 10.9 | 533gf/cm |
| 6 | | Diethylene glycol mono-n-butyl ether | 150g/L | 2 | 4 | 10g/L | - | 13.1 | 3-aminopropyltriethoxysilane | 20g/L | Diethylenetriamine | 10.8 | 560gf/cm |
| 7 | Ethylene glycol types | Diethylene glycol mono-n-butyl ether | 150g/L | 2 | 4 | 5g/L | - | 12.5 | 3-aminopropyltriethoxysilane | 20g/L | Diethylenetriamine | 10.8 | 551gf/cm |
| 8 | | Diethylene glycol mono-n-butyl ether | 150g/L | 2 | 4 | 10g/L | - | 13.1 | 3-aminopropyltriethoxysillane | 30g/L | Diethylenetriamine | 10.5 | 560gf/cm |
| 9 | | Diethylene glycol mono-n-butyl ether | 300g/L | 2 | 4 | 10g/L | - | 13.0 | 3-aminopropyltriethoxysilane | 20g/L | Diethylenetriamine | 10.8 | 575gf/cm |
| 10 | | Diethylene glycol mono-n-butyl ether | 150g/L | 2 | 4 | 10g/L | - | 13.1 | N-2-(aminoethyl)-3-aminopropyltrimethoxysilane | 20g/L | Diethylenetriamine | 10.8 | 512gf/cm |
| 11 | | i Diethylene glycol mono-n-butyl ether | 150g/L | 2 | 4 | 20g/L | - | 13.5 | 3-aminopropyltriethoxysilane | 20g/L | Diethylenetriamine | 10.8 | 565gf/cm |
| 12 | | Triethylene glycol mono-ethyl ether | 150g/L | 3 | 2 | 10g/L | - | 13.1 | 3-aminopropyltriethoxysilane | 20g/L | Diethylenetriamine | 10.8 | 524gf/cm |
| 13 | | Triethylene glycol mono-n-butyl ether | 150g/L | 3 | 4 | 10g/L | - | 13.1 | 3-aminopropyltriethoxysilane | 20g/L | Diethylenetriamine | 10.8 | 520gf/cm |
| 14 | | Tetraethylene glycol monomethyl ether | 150g/L | 4 | 1 | 10g/L | - | 13.1 | 3-aminopropyltriethoxysilane | 20giL | Diethylenetriamine | 10.8 | 533gf/cm |
| 15 | | Propylene glycol mono-methyl ether | 150g/L | 1 | 1 | 10g/L | - | 13.1 | 3-aminopropyltriethoxysilane | 20g/L | Diethylenetriamine | 10.8 | 546gf/cm |
| 16 | | Propylene glycol mono-ethyl ether | 150g/L | 1 | 2 | 10g/L | - | 13.1 | 3-aminopropyltriethoxysilane | 20g/L | Diethylenetriamine | 10.8 | 528gf/cm |
| 17 | Propylene glycol types | Propylene glycol mono-propyl ether | 150g/L | 1 | 3 | 10g/L | - | 13.1 | 3-aminopropyltriethoxysilane | 20g/L | Diethylenetriamine | 10.8 | 548gf/cm |
| 18 | | Dipropylene glycol monomethyl ether | 150g/L | 2 | 1 | 10g/L | - | 13.1 | 3-aminopropyltriethoxysilane | 20g/L | Diethylenetriamine | 10.8 | 521gf/cm |
| 19 | | Tripropylene glycol monomethyl ether | 150g/L | 3 | 1 | 10g/L | - | 13.1 | 3-aminopropyltriethoxysilane | 20g/L | Diethylenetriamine | 10.8 | 531gf/cm |

**[Table 1B]**

| Test No. | First treating solution | | | | | | | | Second treating solution | | | | Adhesion |
|---|---|---|---|---|---|---|---|---|---|---|---|---|---|
| | Glycol ether | | | n or y | m or x | Concentration of pH adjusting agent | | pH | Silane coupling agent | | pH adjusting agent | pH | |
| | Classification | Type | Concentration | | | NaOH | Sulfuric acid | | Type | Concentration | | | Peel strength |
| 20 | | Diethylene glycol mono-n-butyl ether | 20g/L | 2 | 4 | 10g/L | - | 13.1 | 3-aminopropyltriethoxysilane | 20g/L | Diethylenetriamine | 10.8 | 345gf/cm |
| 21 | | Diethylene glycol mono-n-butyl ether | 150g/L | 2 | 4 | 2g/L | - | 11.9 | 3-aminapropyltriethoxysilane | 20g/L | Sulfuric acid | 5.5 | 339gf/cm |
| 22 | | Diethylene glycol mono-n-butyl ether | 150g/L | 2 | 4 | 2g/L | - | 11.9 | 3-aminopropytriethoxysilane | 20g/L | Sulfuric acid | 6.6 | 455gf/cm |
| 23 | | Diethylene glycol mono-n-butyl ether | 150g/L | 2 | 4 | 10g/L | - | 13.1 | 3-aminopropyltriethoxysilane | 20g/L | Sulfuric acid | 1.6 | 420gflcm |
| 24 | | Diethylene glycol mono-n-butyl ether | 150g/L | 2 | 4 | - | 5g/L | 1.5 | 3-aminopropyltriethoxysilane | 20g/L | Diethylenetriamine | 10.8 | 130gf/cm |
| 25 | | Diethylene glycol mono-n-butyl ether | 150g/L | 2 | 4 | - | - | 4.9 | 3-aminapropyltriethoxysilane | 20g/L | Diethylenetriamine | 10.8 | 189gf/cm |
| 26 | Ethylene glycol types | Diethylene glycol mono-n-butyl ether | 150g/L | 2 | 4 | 1g/L | 1g/L | 5.9 | 3-aminopropyltriethoxysilane | 20g/L | Diethylenetriamine | 10.8 | 445gf/cm |
| 27 | | Diethylene glycol mono-n-butyl ether | 150g/L | 2 | 4 | 10g/L | - | 13.1 | 3-aminopropyltriethoxysilane | 2g/L | Diethylenetriamine | 10.9 | 380gf/cm |
| 28 | | Diethylene glycol mono-n-butyl ether | 150g/L | 2 | 4 | 10g/L | - | 13.1 | 3-glycidoxypropyltrimethosilane | 20g/L | Sulfuric acid | 1.5 | 413gf/cm |
| 29 | | Diethylene glycol mono-n-butyl ether | 150g/L | 2 | 4 | 10g/L | - | 13.1 | 3-ureidopropyltriethoxysilane | 20g/L | Sulfuric acid | 1.5 | 348gf/cm |
| 30* | | Diethylene glycol mono-n-butyl ether | 150g/L | 2 | 4 | 10g/L | - | 13.1 | 3-aminopropyltriethoxysilane | 20g/L | Diethylenetriamine | 10.8 | 234gf/cm |
| 31 | | Diethylene glycol mono-n-butyl ether | 150g/L | 2 | 4 | 10g/L | - | 13.1 | - | - | - | - | 135gf/cm |
| 32 | | Diethylene glycol mono-n-butyl ether | 150g/L | 2 | 4 | 10g/L | - | 13.1 | - | - | Diethylenetriamine | 11.1 | 140gf/cm |
| 33 | - | | - | - | - | 10g/L | - | 13.1 | 3-aminopropyltriethoxysilane | 20g/L | Diethylenetriamine | 10.8 | 285gf/cm |
| 34 | - | | - | - | - | - | - | - | 3 -aminopropyltriethoxysilane | 20g/L | Diethylenetriamine | 10.8 | 255gf/cm |
| 36 | N-methyl-2-pyrrolidone | | 150g/L | - | - | 10g/L | - | 13.1 | 3-aminopropyltriethoxysilane | 20g/L | Diethylenetriamine | 10.8 | 400gf/cm |

| | | | | | | | | | | | | | |
|---|---|---|---|---|---|---|---|---|---|---|---|---|---|
| Note: Test No. 30* is an example in which a treatment with a First treating solution is carried out after a treatment with a Second treating solution. | | | | | | | | | | | | | |

**[Table 2]**

| Steps | | Name of chemicals | Concentration | Treating temperature (°C) | Treating time (min.) |
|---|---|---|---|---|---|
| Swelling | | APPDES MDS-37 available from C. Uyemura & Co., Ltd. | 500mL/L | 60 | 5 |
| Roughening | | MDE-40 available from C. Uyemura & Co., Ltd. | 100mL/L | 80 | 15 |
| | | ELC-SH available from C. Uyemura & Co., Ltd. | 140mL/L | | |
| Neutralization | | MDN-62 available from C. Uyemura & Co., Ltd. | 100mL/L | 45 | 5 |
| | | MDN-AD available from C. Uyemura & Co., Ltd. | 150mL/L | | |
| Ultrasonic treatment | | | | 25 | 5 |
| First treating solution | | See Tables 1A and 1B | | 80 | 10 |
| Second treating solution | | See Tables 1A and 1B | | 60 | 10 |
| Drying | | | | | |
| Cleaner/Conditioner | | THRU-CUP MCD-PL available from C. Uyemura & Co., Ltd. | 50mL/L | 40 | 5 |
| Soft etching | | Sodium persulfate | 100g/L | 26 | 1 |
| | | Sulfuric acid | 100g/L | | |
| Pickling | | Sulfuric acid | 100g/L | 25 | 1 |
| Catalyst imparting | Pre dip | ALCUP MDP-2 available from C. Uyemura & Co., Ltd. | 10mL/L | 25 | 2 |
| | | Sulfuric acid | 3g/L | | |
| | Activator | ALCUP MAT-SP available from C. Uyemura & Co., Ltd. | 50mL/L | 40 | 5 |
| | | 1N-NaOH | 40mL/L | | |
| | Reducer | ALCUP MAB-4-A available from C. Uyemura & Co., Ltd. | 10mL/L | 35 | 3 |
| | | ALCUP MAB-4-C available from C. Uyemura & Co., Ltd. | 50mL/L | | |
| | | ALCUP MRD-2-C available from C. Uyemura & Co., Ltd. | 10mL/L | | |
| | Accelerator | THRU-CUP MEL-3-A available from C. Uyemura & Co., Ltd. | 50mL/L | 25 | 1 |
| Electroless copper plating | | THRU-CUP PEA-6-A available from C. Uyemura & Co., Ltd. | 100mL/L | 36 | 15 |
| | | THRU-CUP PEA-6-B-2X available from C. Uyemura & Co., Ltd. | 50mL/L | | |
| | | THRU-CUP PEA-6-C available from C. Uyemura & Co., Ltd. | 14mL/L | | |
| | | THRU-CUP PEA-6-D available from C. Uyemura & Co., Ltd. | 15mL/L | | |
| | | THRU-CUP PEA-6-E available from C. Uyemura & Co., Ltd. | 50mL/L | | |
| Drying | | | | | |
| Heat treatment | | | | 150 | 30 |
| Cleaner | | THRU-CUP MSC-3-A available from C. Uyemura & Co., Ltd. | 100mL/L | 40 | 5 |
| Pickling | | Sulfuric acid | 100g/L | 25 | 1 |
| Electrolytic copper plating | | THRU-CUP ETN (2.5 A/dm²) available from C. Uyemura & Co., Ltd. | | 25 | 45(25um) |
| Decoloration prevention | | THRU-CUP AT-21 available from C. Uyemura & Co., Ltd. | 1mL/L | 25 | 1 |
| Drying | | | | | |
| Heat treatment | | | | 180 | 60 |

The following discussion can be made from Table 1.

First, Test Nos. 1 to 19 are Working Examples using procedures including a two-step treating process. In all the cases of ethylene-based glycol types (Nos. 1 to 14) or propylene-based glycol types (No. 15 to 19), the peel strength was 500 gf/cm or more and thus adhesion to a plating film was excellent.

Test No. 20 is a reference example in which the concentration of glycol ether in ethylene glycol (first treating solution) was low, and then adhesion was lowered.

Likewise, Test No. 27 is a reference example in which the concentration of a silane coupling agent (second treating solution) was low, and then adhesion was lowered.

On the other hand, the followings were comparative examples using treating solutions failing to satisfy any of the requirements of the present invention. These examples had the following problems.

Test Nos. 21 to 23 were examples in which sulfuric acid was used to adjust a pH to be lower than 7.0 in a second treating solution, and then adhesion was lowered.

Test No. 24 to 26 were examples in which a pH was adjusted to be lower than 7 by using a pH adjusting agent and the like in a first treating solution, and then adhesion was lowered.

Test Nos. 28 and 29 were examples in which a silane coupling agent other than amine-based one was used and a pH was controlled to be lower than 7.0 by using sulfuric acid in a second treating solution, and then adhesion was lowered.

Test No. 30 was an example in which an order of processes of the present invention was reversed. Because the example was treated with a first treating solution after a treatment with a second treating solution, adhesion was lowered.

Test No. 31 was an example in which only a treatment with a first treating solution was carried out without being followed by a treatment with a second treating solution (an amine-based silane coupling agent and a pH adjusting agent), and then adhesion was lowered.

Test No. 32 was an example in which only diethylenetriamine, which was a pH adjusting agent, was added without addition of an amine-based silane coupling agent in a second treating solution, and then adhesion was lowered.

Test No. 33 was an example in which NaOH, which was a pH adjusting agent, whose concentration was 10 g/L was added without addition of glycol ether in a first treating solution, and then adhesion was lowered.

Test No. 34 was an example in which only a treatment with a second treating solution was carried out without being preceded by a treatment with a first treating solution (glycol ether and a pH adjusting agent), and adhesion was lowered.

Test No. 35 was a comparative example in which N-methyl-2-pyrrolidone, which was commonly used in swelling process, was used instead of a first treating solution, and adhesion was lowered.

These results have demonstrated that in order to achieve desired adhesion, it is useful to carry out processes in a designated order with designated treating solutions as specified in the present invention.

## Claims

1. A method for producing a printed wiring board, the method comprising the steps of:
subjecting a filler-containing insulating resin substrate to a swelling treatment;
a roughening treatment;
a reduction treatment; and
electroless plating,
wherein the filler-containing insulating resin substrate after the reduction treatment is treated with a first treating solution and a second treating solution, and then is subjected to the electroless plating,
wherein the first treating solution has a pH of 7 or higher and comprises:
at least one selected from the group consisting of ethylene-based glycol ether represented by CmH(2m+1)-(OC₂H₄)n-OH, where m = an integer of 1 to 4, n = an integer of 1 to 4, and propylene-based glycol ether represented by CxH(2x+1)-(OC₃H₆)y-OH, where x = an integer of 1 to 4, y = an integer of 1 to 3, and wherein the second treating solution has a pH of 7.0 or higher and comprises an amine-based silane coupling agent.

2. The method according to claim 1, wherein the filler-containing insulating resin substrate after the treatment with the second treating solution is subjected to a cleaning treatment and then the electroless plating.
